Europäisches Patentamt

European Patent Office

Office européen des brevets

(19)

(11) Publication number : **0 459 071 B1**

(12) ## EUROPEAN PATENT SPECIFICATION

(45) Date of publication of patent specification :
**17.08.94 Bulletin 94/33**

(51) Int. Cl.[5] : **H03F 3/72, H03F 1/30**

(21) Application number : **90830248.2**

(22) Date of filing : **31.05.90**

(54) **Offset and slew-rate equalization and control for a pair of voltage-to-current transducers using the same reference voltage.**

(43) Date of publication of application :
**04.12.91 Bulletin 91/49**

(45) Publication of the grant of the patent :
**17.08.94 Bulletin 94/33**

(84) Designated Contracting States :
**DE FR GB IT NL SE**

(56) References cited :
**FR-A- 2 148 774
US-A- 4 177 432
ALTA FREQUENZA. vol. 51, no. 6, November
1982, MILANO IT pages 328 - 333; P.F. Man-
fredi et al: "Realization of some analog func-
tions with switchable feedback loops"**

(73) Proprietor : **SGS-THOMSON
MICROELECTRONICS s.r.l.
Via C. Olivetti, 2
I-20041 Agrate Brianza Milano (IT)**

(72) Inventor : **Salina, Alberto
Viale Piave 20
I-20051 Limbiate (IT)**

(74) Representative : **Pellegri, Alberto et al
c/o Società Italiana Brevetti S.p.A.
Via Puccini, 7
I-21100 Varese (IT)**

EP 0 459 071 B1

## Description

### 1. Field of the invention

The present invention relates to a circuit for equalizing the offset and the slew-rate of a pair of voltage-to-current transducers using the same reference voltage.

### 2. Description of the prior art

In regulation, control and analog/digital conversion systems, pairs of voltage-to-current transducer circuits using the same reference voltage (control voltage) are often employed. In these circuits it is comprehensively essential to guarantee an identical offset and slew-rate behaviour of the two transducers.

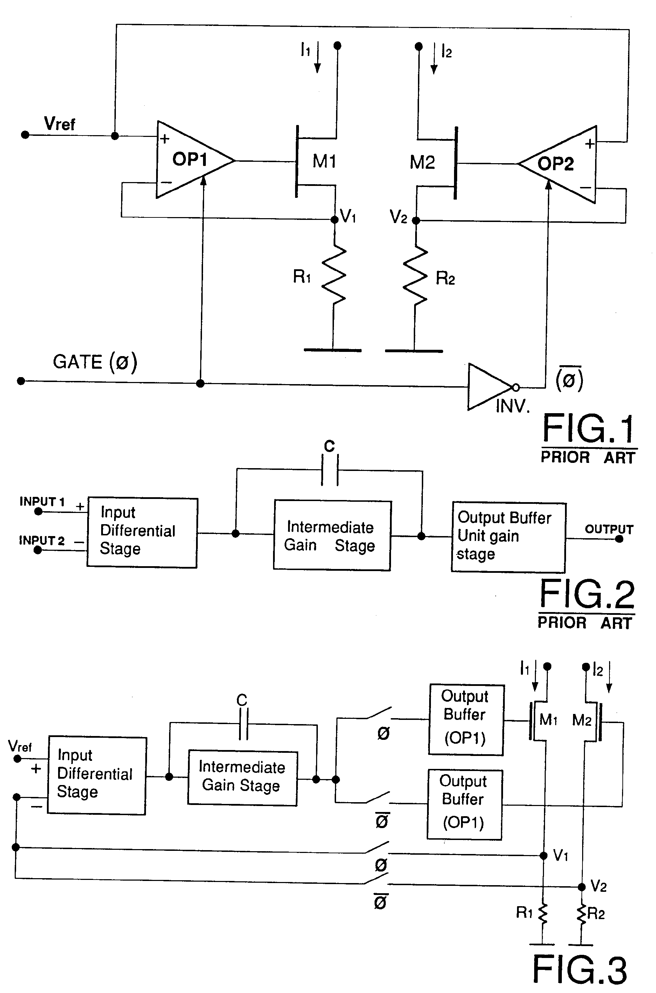

Commonly the circuit employed is substantially the one shown in Fig. 1. The two operational amplifiers OP1 and OP2 use the same reference voltage $V_{ref}$ and constitute two feedback loops together with the respective feedback transistors M1 and M2; the two loops regulate the voltages $V_1$ and $V_2$ to a value equal to $V_{ref}$. The currents flowing through the transistors M1 and M2 will be given by: $I_1 = V_1/R_1$ and $I_2 = V_2/R_2$, respectively. Of course the two transistors $M_1$ and $M_2$ may be MOS transistors (e.g. DMOS) or bipolar transistors (e.g. NPN). The pair of phase-opposed GATE signals ($\phi$ and $\bar{\phi}$) operatively enables the operational amplifiers OP1 and OP2, alternately.

In such a circuit it is important to ensure precision of the regulated voltages $V_1$ and $V_2$ in respect to $V_{ref}$, as well as of the respective response times to a step variation of the $V_{ref}$ value.

The main causes of error are:
- residual offset differences between the two operational amplifiers OP1 and OP2;
- electrical potential differences between the ground potential of the sensing resistors R1 and R2 and the ground potential of the operational amplifiers OP1 and OP2;
- slew-rate differences between the operational amplifiers due to the capacitive pairing relative to the two compensation capacitors needed for determining a correct small-signal frequency response of the two amplifiers, beside differences of the current generators responsible for the charge and discharge time of the two compensation capacitors.

In order to obviate to these problems it is normally necessary to carry out accurate internal trimmings on each one of the two operational amplifiers so as to minimize the residual offset of each operational amplifer. The block diagram of an operational amplifier is depicted in Fig. 2. The input differential stage and the intermediate gain stage have a gain commonly comprised between 300 and 1000 each and are followed by an unitary gain output stage or buffer, which may typically be an emitter follower stage. The emitter follower output stage reduces the output impedance so as to be able to drive relatively low impedance loads.

### SUMMARY OF THE INVENTION

It has now been found that a substantial identity of residual offset and equalization of the slew-rate of the two transducers may be obtained using a lesser number of components and by carrying out a single offset correction trimming intervention, by employing the improved equalization and control circuit, object of the present invention.

The circuit of the invention utilizes substantially a single control operational amplifier core, formed by a single input differential stage and a single intermediate gain stage and employs two distinct unitary gain output stages for driving the feedback transistors of the two voltage-to-current transducers. The voltages detected across the two sensing resistors are alternately fed to the differential input stage of the amplifier by employing two switches driven by the pair of GATE signals ($\phi$ and $\bar{\phi}$), which signals, through another pair of switches, operatively connect the output of the intermediate gain stage to the input of one or of the other of the two unitary gain output stages.

### BRIEF DESCRIPTION OF THE DRAWINGS

**Fig. 1** is the circuit diagram of the offset and slew-rate control and equalization circuit of a pair of voltage-to-current transducers, in accordance with the prior art.

**Fig. 2** is a typical block diagram of an operational amplifier of the type employed in the control circuit of Fig. 1.

**Fig. 3** is the circuit diagram of an offset and slew-rate control and equalization circuit for a pair of voltage-to-current transducers, in accordance with the present invention.

### DESCRIPTION OF THE PREFERRED EMBODIMENT

The circuit of the invention is shown in Fig. 3 using the same symbols and legends for indicating the same parts which have been already described in relation to Figures 1 and 2 which are illustrative of the prior art.

The analog switches are schematically shown in Fig. 3 and for each one of them it is indicated the relative GATE signal which enables, i.e. closes, the switch. The pair of phase-opposed GATE signals, respectively $\phi$ and $\bar{\phi}$ may be obviously obtained by employing an inverter for obtaining the inverted phase signal ($\bar{\phi}$).

In the control circuit of the invention, the high gain stages of the two control loops are common while only the unitary gain output stage is "duplicated". The relative unitary gain output stage is selected by means of a respective analog switch driven by one of the signals of the pair of phase-opposed GATE signals. The advantage which is derived from this configuration is that, by carrying out a single trimming of the high gain stages (i.e. the differential input stage and the intermediate gate stage) it is possible to compensate the offset error between $V_{ref}$ and $V_1$, while automatically obtaining the same identical precision also between $V_{ref}$ and $V_2$ (by being the output stage's gain equal to 1).

Also the slew-rate time is substantially equalized because primarily a single compensation capacitance C is used and therefore the criticality of capacitance pairing is eliminated. On the other hand, though a difference may still exist between the charging currents of the unique compensation capacitance C (because of differences of the currents generated by the current generators of the output stage), this difference may be easily minimized in view of the relatively ease in obtaining precision levels below 0.5% in this kind of pairing among, integrated current generators.

## Claims

1. An offset and slew-rate equalization and control circuit for a pair of voltage-to-current transducers using the same reference voltage (Vref) each one of which substantially comprises a grounded sensing resistance ($R_1$, $R_2$) across which a voltage signal, essentially equal to said reference voltage, develops and a feedback transistor ($M_1$, $M_2$), having an emitter or source connected to said sensing resistance, a collector or drain terminal through which said current signal, function of said reference voltage, is generated and a base or gate to which a control signal produced on an output terminal by a control operational amplifier, enabled by a first enabling signal in phase opposition to a second enabling signal of a control operational amplifier of the other transducer of the pair, to a noninverting input of which is fed said reference voltage while to an inverting input of which said voltage signal is applied, characterized by comprising an unique control operational amplifier core formed by an input differential stage having an inverting input and a noninverting input and an output, an intermediate gain stage having an input connected to the output of said input differential stage and an output, and two distinct unitary gain output stages, each having an input capable of being connected to the output of said intermediate gain stage and an output respectively connected to the base or gate of one and of the other of said two feedback transistors;

said reference voltage being applied to the noninverting input of said input differential stage;

the inverting input of said input differential stage being alternately connected by means of analog switches driven by said phase-opposed enabling signals ($\phi$, $\bar{\phi}$), to one and the other of said sensing resistances;

the output of said intermediate gain stage being functionally connected alternately, by means of analog switches driven by said phase-opposed enabling signals, respectively to the input of one or the other of said unitary gain output stages.

## Patentansprüche

1. Offset- und Anstiegsgeschwindigkeits-Ausgleichs- und -Steuerschaltung für ein Paar Spannungs-Strom-Wandler unter Verwendung derselben Bezugsspannung (Vref), von denen jeder im wesentlichen einen auf Masse gelegten Abtastwiderstand (R1, R2), an dem sich ein Spannungssignal entwickelt, welches im wesentlichen der Bezugsspannung gleicht, und einen Rückkopplungstransistor (M1, M2) aufweist, welcher einen Emitter oder eine Source aufweist, die an den Abtastwiderstand angeschlossen ist, der einen Kollektor- oder Drainanschluß besitzt, über den das Stromsignal als Funktion der Bezugsspannung erzeugt wird, und der eine Basis oder ein Gate besitzt, welchem ein an einem Ausgangsanschluß durch einen Steuer-Operationsverstärker gebildetes Steuersignal zugeführt wird, welcher durch ein erstes Aktivierungssignal aktiviert wird, welches in der Phase entgegengesetzt zu einem zweiten Aktivierungssignal eines Steuer-Operationsverstärkers des anderen Wandlers des Wandlerpaares ist, wobei einem nicht-invertierenden Eingang des Operationsverstärkers die Bezugsspannung und dem invertierenden Eingang das Spannungssignal zugeführt wird,
gekennzeichnet durch:
einen einheitlichen Steuer-Operationsverstärker-Kern, gebildet durch eine Eingangs-Differenzstufe mit einem invertierenden Eingang, einem nicht-invertierenden Eingang und einem Ausgang, einer Zwischenverstärkungsstufe, die mit einem Eingang an den Ausgang der Eingangs-Differenzstufe angeschlossen ist, und die einen Ausgang besitzt und zwei diskreten Ausgangsstufen mit der Verstärkung eins, die jeweils einen Eingang besitzen, der an den Ausgang der Zwischenverstärkungsstufe anschließbar ist, und mit einem Ausgang an die Basis oder das Gate des einen und des anderen der beiden Rückkopplungstransistoren angeschlossen ist;

wobei die Bezugsspannung an den nicht-invertierenden Eingang der Eingangs-Differenzstufe gelegt wird;

der invertierende Eingang der Eingangs-Differenzstufe mit Hilfe von Analogschaltern, die durch die in der Phase entgegengesetzten Aktivierungssignale ($\phi$, $\bar{\phi}$) getrieben werden, abwechselnd an den einen oder den anderen der Abtastwiderstände angeschlossen wird;

der Ausgang der Zwischenverstärkungsstufe mit Hilfe von Analogschaltern, die durch die in der Phase entgegengesetzten Aktivierungssignale angesteuert werden, funktionell abwechselnd an den Eingang der einen oder der anderen Ausgangsstufe mit der Verstärkung von eins angeschlossen wird.

**Revendications**

1. Circuit d'égalisation et de commande de tension de décalage et de temps de réponse pour une paire de transducteurs tension-courant utilisant la même tension de référence ($V_{ref}$) dont chacun comprend sensiblement une résistance de détection mise à la masse (R1, R2) aux bornes de laquelle un signal de tension, fondamentalement égal à la tension de reference se développe, et un transistor de réaction (M1, M2) ayant un émetteur ou source connecté à la résistance de détection, une borne de collecteur ou de drain à travers laquelle est produit le signal de courant, fonction de la tension de référence, et une base ou grille à laquelle est fourni un signal de commande produit sur une borne de sortie par un amplificateur opérationnel de commande, validé par un premier signal de validation en opposition de phase avec un second signal de validation d'un amplificateur opérationnel de commande de l'autre transducteur de la paire, à une entrée non-inverseuse duquel est fournie la tension de référence tandis que ledit signal de tension est appliqué à son entrée inverseuse,

caractérisé en ce qu'il comprend :

un amplificateur opérationnel de commande à coeur unique constitué d'un étage différentiel d'entrée ayant une entrée inverseuse et une entrée non-inverseuse et une sortie, d'un étage de gain intermédiaire ayant une entrée connectée à la sortie de l'étage différentiel d'entrée et une sortie, et de deux étages de sortie distincts à gain unité dont chacun a une entrée susceptible d'être connectée à la sortie de l'étage de gain intermédiaire et une sortie respectivement connectée à la base ou grille de l'un ou l'autre des deux transistors de réaction ;

la tension de référence étant appliquée à l'entrée non-inverseuse de l'étage différentiel d'entrée ;

l'entrée inverseuse de l'étage différentiel d'entrée étant alternativement connectée par des commutateurs analogiques pilotés par les signaux de validation opposés en phase ($\phi$, $\bar{\phi}$) à l'une et l'autre des résistances de détection ;

la sortie de l'étage de gain intermédiaire étant fonctionnellement alternativement connectée, au moyen de commutateurs analogiques pilotés par des signaux de validation opposés en phase, respectivement à l'entrée de l'un ou de l'autre des étages de sortie à gain unité.

**FIG.1**
_PRIOR ART_

**FIG.2**
_PRIOR ART_

**FIG.3**